# EUROPEAN PATENT APPLICATION

(11) **EP 4 166 698 A1**
(43) Date of publication of application: **19.04.2023**
(21) Application number: 21822491.3
(22) Date of filing: 07.06.2021
(51) Int. Cl.: C30B 29/42, C30B 11/00

(54) **GAAS INGOT, METHOD FOR MANUFACTURING GAAS INGOT, AND GAAS WAFER**

(30) Priority: 12.06.2020 JP 2020102685; 05.10.2020 JP 2020168751
(71) Applicant: DOWA Electronics Materials Co., Ltd., Tokyo 101-0021 (JP)
(72) Inventor: SUNACHI, Naoya, Tokyo 101-0021 (JP); TOBA, Ryuichi, Tokyo 101-0021 (JP); AKAISHI, Akira, Tokyo 101-0021 (JP)
(74) Representative: Müller-Boré & Partner Patentanwälte PartG mbB
(86) International application number: PCT/JP2021/021626
(87) International publication number: WO 2021/251349

(57) **Abstract**

Provided is a GaAs ingot with which a GaAs wafer having a carrier concentration of 5.5 × 10¹⁷ cm⁻³ or less and low dislocation density with an average dislocation density of 500/cm² or less can be obtained by adding a small amount of In with Si.
A seed side end and a center portion of a straight body part of the GaAs ingot each have a silicon concentration of 2.0 × 10¹⁷ cm⁻³ or more and less than 1.5 × 10¹⁸ cm⁻³, an indium concentration of 1 × 10¹⁷ cm⁻³ or more and less than 6.5 × 10¹⁸ cm⁻³, a carrier concentration of 5.5 × 10¹⁷ cm⁻³ or less, and an average dislocation density of 500/cm² or less.

## Description

### TECHNICAL FIELD

This disclosure relates to a GaAs ingot and a method of producing a GaAs ingot, and a GaAs wafer.

### BACKGROUND

Known methods of producing a GaAs crystal (ingot) for obtaining a GaAs single crystal wafer (hereinafter also referred to as a GaAs wafer) include a pulling (LEC) method, the horizontal boat (HB) method, the vertical gradient freeze (VGF) method, and the vertical Bridgman (VB) method. A block of a single crystal that is obtained by crystal growth from a seed crystal of a single crystal using these production methods and has a straight body part is an ingot. Wafers are cut from the straight body part of the ingot.

Of the above methods, with the LEC method, the dislocation density of a GaAs wafer is hardly reduced. There has been a temporary trend toward a technique of eliminating dislocations by the LEC method using indium (In) doping; however, because of heavy In doping to an extent that an alloy of GaAs and In is regarded as being formed, a large quantity of In is precipitated, and wafers obtained using this technique have been found to be unusable as a product. At the present, the LEC method using In doping is no longer used.

On the other hand, JP 2011-148693 A (PTL 1) describes an n-type gallium arsenide substrate that is obtained using the VGF method or the VB method and has an average dislocation density of less than 100/cm² and a silicon concentration of 5 × 10¹⁶ cm⁻³ or more and less than 5 × 10¹⁷ cm⁻³.

### CITATION LIST

### Patent Literature

PTL 1: JP 2011-148693 A

### SUMMARY

### (Technical Problem)

In recent years, GaAs wafers having a carrier concentration of 5.5 × 10¹⁷ cm⁻³ or less and low dislocation density have come to be desired as substrates particularly used in light emitting/receiving elements such as light-emitting elements and light-receiving elements.

In PTL 1, in order to obtain both low silicon (Si) concentration and low average dislocation density, it is important to retain the super-cooled state and precisely control the temperature gradient of the solid-liquid interface, and to achieve those, as a seed crystal used to grow a GaAs ingot, a seed crystal having a cross-sectional area that is 25 % or more of the body part of a single crystal to be grown is used. When a seed crystal having such a large cross-sectional area is used, at the start of crystal growth, the entire cross section of the seed crystal is necessarily dissolved; accordingly, in the case of the VGF method or the VB method, it is necessary to make uniform the temperature distribution near the seed crystal in the horizontal direction in the crucible containing the seed crystal and feedstocks. Now, the temperature distribution in the crucible containing the seed crystal and feedstocks cannot be directly measured and is controlled through temperature control of a heater placed around the crucible. Further, the relationship between the heater temperature and the temperature in the crucible may change depending on the degradation of members such as a heat insulator in the crucible. Such a structural problem makes it difficult to well reproduce the high uniformity of the temperature distribution near the seed crystal in the horizontal direction in the crucible containing the seed crystal and feedstocks, resulting in a bottleneck in obtaining a GaAs ingot having low Si concentration and low average dislocation density. Further, the weight of the seed crystal used in this method is large, resulting in an increase in the production cost.

This being the case, it could be helpful to provide a GaAs ingot with which a GaAs wafer having a carrier concentration of 5.5 × 10¹⁷ cm⁻³ or less and low dislocation density with an average dislocation density of 500/cm² or less can be obtained even when using a seed crystal having a small cross-sectional area using the VGF method or the VB method. It could be particularly helpful to provide a GaAs ingot with which a GaAs wafer having a carrier concentration of 5.5 × 10¹⁷ cm⁻³ or less and an average dislocation density of 500/cm² or less can be obtained even when the wafer has a large diameter of 140 mm or more, and to provide a GaAs ingot with which a GaAs wafer having a carrier concentration of 5.0 × 10¹⁷ cm⁻³ or less and an average dislocation density of 200/cm² or less can be obtained when the wafer has a diameter of less than 140 mm.

### (Solution to Problem)

The present inventors diligently made studies to address the above challenges and this led to this disclosure described below.

This disclosure primarily includes the following features.
[1] A GaAs ingot comprising a straight body part,
   wherein a seed side end and a center portion of the straight body part each have a silicon concentration of 2.0 × 10¹⁷ cm⁻³ or more and less than 1.5 × 10¹⁸ cm⁻³, an indium concentration of 1.0 × 10¹⁷ cm⁻³ or more and less than 6.5 × 10¹⁸ cm⁻³, a carrier concentration of 5.5 × 10¹⁷ cm⁻³ or less, and an average dislocation density of 500/cm² or less.
[2] The GaAs ingot according to [1] above, wherein the indium concentration in the center portion of the straight body part is 6.0 × 10¹⁸ cm⁻³ or less.
[3] The GaAs ingot according to [1] or [2] above, wherein the boron concentration in each of the seed side end and the center portion of the straight body part is 1.0 × 10¹⁸ cm⁻³ or more and 6.5 × 10¹⁸ cm⁻³ or less.
[4] The GaAs ingot according to any one of [1] to [3] above, wherein a ratio of the indium concentration to the silicon concentration for each of the seed side end and the center portion of the straight body part is 0.30 or more and 10.00 or less.
[5] The GaAs ingot according to any one of [1] to [4] above, wherein the concentrations of aluminum, carbon, and zinc in each of the seed side end and the center portion of the straight body part are 3.0 × 10¹⁶ cm⁻³ or less; and the concentrations of beryllium, magnesium, germanium, tin, nitrogen, sulfur, selenium, tellurium, cadmium, chromium, and antimony are 5.0 × 10¹⁵ cm⁻³ or less in each of the seed side end and the center portion of the straight body part.
[6] The GaAs ingot according to any one of [1] to [5] above, wherein the diameter of the GaAs ingot is less than 140 mm; and the seed side end and the center portion of the straight body part of the GaAs ingot each have a silicon concentration of 2.0 × 10¹⁷ cm⁻³ or more and less than 1.0 × 10¹⁸ cm⁻³, an indium concentration of 1.0 × 10¹⁷ cm⁻³ or more and less than 3.0 × 10¹⁸ cm⁻³, a carrier concentration of 5.0 × 10¹⁷ cm⁻³ or less, and an average dislocation density of 200/cm² or less.
[7] The GaAs ingot according to [6] above, wherein the indium concentration in the center portion of the straight body part is 2.0 × 10¹⁸ cm⁻³ or less.
[8] The GaAs ingot according to [6] or [7] above, wherein the boron concentration in each of the seed side end and the center portion of the straight body part is 1.0 × 10¹⁸ cm⁻³ or more and 5.0 × 10¹⁸ cm⁻³ or less.
[9] The GaAs ingot according to any one of [6] to [8] above, wherein a ratio of the indium concentration to the silicon concentration for each of the seed side end and the center portion of the straight body part is 0.30 or more and 5.20 or less.
[10] The GaAs ingot according to any one of [1] to [5] above, wherein the diameter of the GaAs ingot is 140 mm or more; and the seed side end and the center portion of the straight body part of the GaAs ingot each have a silicon concentration of 2.0 × 10¹⁷ cm⁻³ or more and less than 1.5 × 10¹⁸ cm⁻³, an indium concentration of 1.0 × 10¹⁸ cm⁻³ or more and less than 6.5 × 10¹⁸ cm⁻³, a carrier concentration of 5.5 × 10¹⁷ cm⁻³ or less, and an average dislocation density of 500/cm² or less.
[11] The GaAs ingot according to [10] above, wherein the indium concentration in the center portion of the straight body part is 6.0 × 10¹⁸ cm⁻³ or less.
[12] The GaAs ingot according to [10] or [11] above, wherein the boron concentration in each of the seed side end and the center portion of the straight body part is 1.0 × 10¹⁸ cm⁻³ or more and 6.5 × 10¹⁸ cm⁻³ or less.
[13] The GaAs ingot according to any one of [10] to [12] above, wherein a ratio of the indium concentration to the silicon concentration for each of the seed side end and the center portion of the straight body part is 4.50 or more and 10.00 or less.
[14] A method of producing a GaAs ingot by a vertical temperature gradient method or a vertical Bridgman method using silicon as a dopant and using boron oxide as a sealant,
   wherein indium is used together with silicon as the dopant,
   wherein the seed side end and the center portion of the straight body part of the GaAs ingot each have a silicon concentration of 2.0 × 10¹⁷ cm⁻³ or more and less than 1.5 × 10¹⁸ cm⁻³ and an indium concentration of 1.0 × 10¹⁷ cm⁻³ or more and less than 6.5 × 10¹⁸ cm⁻³.
[15] The method of producing a GaAs ingot, according to [14] above, wherein only silicon and indium are used as the dopant.
[16] The method of producing a GaAs ingot, according to [14] or [15] above, wherein an amount of silicon charged is 60 wt ppm or more and 130 wt ppm or less with respect to a GaAs feedstock, and an amount of indium charged is 36 wt ppm or more and 2000 wt ppm or less with respect to the GaAs feedstock.
[17] The method of producing a GaAs ingot, according to anyone of [14] to [16] above, wherein the sealant is boron oxide containing 1 wt% or more and 7 wt% or less silicon, and is stirred during growth of a GaAs single crystal.
[18] The method of producing a GaAs ingot, according to any one of [14] to [17] above, wherein the GaAs ingot has a diameter of less than 140 mm, an amount of silicon charged is 60 wt ppm or more and 90 wt ppm or less with respect to the GaAs feedstock, and an amount of indium charged is 36 wt ppm or more and 605 wt ppm or less with respect to the GaAs feedstock.
[19] The method of producing a GaAs ingot, according to any one of [14] to [17] above, wherein the GaAs ingot has a diameter of 140 mm or more, an amount of silicon charged is 70 wt ppm or more and 130 wt ppm or less with respect to the GaAs feedstock, and an amount of indium charged is 75 wt ppm or more and 2000 wt ppm or less with respect to the GaAs feedstock.
[20] A GaAs wafer comprising:
   silicon with a concentration of 2.0 × 10¹⁷ cm⁻³ or more and less than 1.5 × 10¹⁸ cm⁻³;
   indium with a concentration of 1.0 × 10¹⁷ cm⁻³ or more and less than 6.5 × 10¹⁸ cm⁻³; and
   carriers with a concentration of 5.5 × 10¹⁷ cm⁻³ or less,
   wherein an average dislocation density of the GaAs wafer is 500/cm² or less.
[21] The GaAs wafer according to [20] above, wherein the diameter of the GaAs wafer is less than 140 mm, a silicon concentration is 2.0 × 10¹⁷ cm⁻³ or more and less than 1.0 × 10¹⁸ cm⁻³, an indium concentration is 1.0 × 10¹⁷ cm⁻³ or more and less than 3.0 × 10¹⁸ cm⁻³, a carrier concentration is 5.0 × 10¹⁷ cm⁻³ or less, and an average dislocation density is 200/cm² or less.
[22] The GaAs wafer according to [20] above, wherein the diameter of the GaAs wafer is 140 mm or more; the seed side end and the center portion of the straight body part of the GaAs ingot each have a silicon concentration of 2.0 × 10¹⁷ cm⁻³ or more and less than 1.5 × 10¹⁸ cm⁻³, an indium concentration of 1.0 × 10¹⁸ cm⁻³ or more and less than 6.5 × 10¹⁸ cm⁻³, a carrier concentration of 5.5 × 10¹⁷ cm⁻³ or less, and an average dislocation density of 500/cm² or less.

### (Advantageous Effect)

This disclosure can provide a GaAs ingot with which a GaAs wafer having a carrier concentration of 5.5 × 10¹⁷ cm⁻³ or less and low dislocation density with an average dislocation density of 500/cm² or less can be obtained by adding a small amount of In with Si even when using a seed crystal having a small cross-sectional area in the VGF method or the VB method. This disclosure can provide a GaAs ingot with which a GaAs wafer having a carrier concentration of 5.5 × 10¹⁷ cm⁻³ or less and an average dislocation density of 500/cm² or less can be obtained even when the wafer has a large diameter of 140 mm or more, and can provide a GaAs ingot with which a GaAs wafer having a carrier concentration of 5.0 × 10¹⁷ cm⁻³ or less and an average dislocation density of 200/cm² or less can be obtained when the wafer has a diameter of less than 140 mm.

### BRIEF DESCRIPTION OF THE DRAWINGS

In the accompanying drawings:
FIG. 1 is a schematic view of a GaAs ingot of this disclosure;
FIG. 2 is a schematic cross-sectional view of a production apparatus used for the production of a GaAs ingot of this disclosure;
FIG. 3 is a schematic cross-sectional view of a crucible 3 used in the production of a GaAs ingot of this disclosure, corresponding to the state where the crucible is charged with feedstock and others before the start of crystal growth; and
FIG. 4 is a diagram illustrating the relationship between the state inside a crucible and the temperature gradient from the start of the crystal growth to the end of crystal growth.

### DETAILED DESCRIPTION

Embodiments of this disclosure will now be described with reference to the drawings.

### < GaAs ingot >

### (Seed side end, center portion, and tail side end of GaAs ingot)

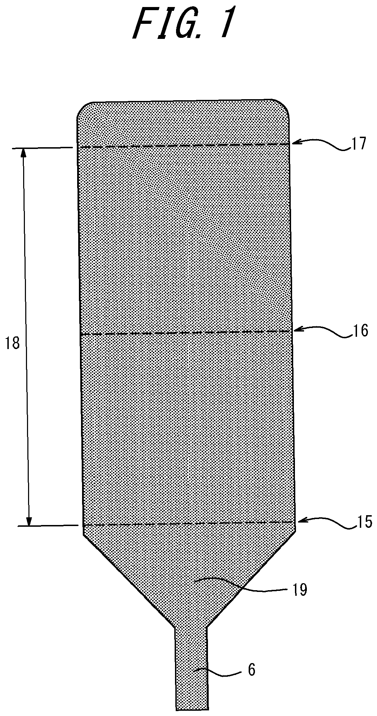

FIG. 1 is a schematic view of a GaAs ingot of this disclosure, illustrating the positions of a seed side end 15, a center portion 16, and a tail side end 17. The GaAs ingot has a region 19 having a diameter increasing from a seed crystal 6 (also referred to as a cone part), and the GaAs ingot has a straight body part 18 having almost the same diameter on the top of region 19; the end of the straight body part 18 on the seed crystal 6 side is referred to as the seed side end 15; the end of the straight body part 18 on the side opposite to the seed crystal 6 is referred to as the tail side end 17; and the middle position (center position) of the straight body part 18 between the seed side end 15 and the tail side end 17 is referred to as a center portion 16. Crystal growth of the GaAs ingot is performed such that the solid-liquid interface shifts from the seed side end 15 to the tail side end 17.

The measured values of the silicon (Si) concentration, the indium (In) concentration, the carrier concentration, and the average dislocation density of each of the seed side end 15, the center portion 16, and the tail side end 17 of the straight body part 18 in the GaAs ingot of this disclosure can be obtained by slicing the straight body part 18 of the GaAs ingot into wafers and performing measurements on given wafers. Specifically, in the measurements, the wafers of the seed side end 15, the center portion 16, and the tail side end 17 of the straight body part 18 in the GaAs ingot are subjected to the measurements.

The diameter of the GaAs ingot 18 is not limited, and may be less than 140 mm and may be 140 mm or more. The diameter of the GaAs ingot 18 may be, for example, 50 mm or more and 162 mm or less. The wafers can have a proper size by selecting the diameter of the straight body part 18 of the GaAs ingot; for example, the size may be 2 in to 8 in. When the diameter of the GaAs ingot 18 is less than 140 mm, the size of the wafers is typically less than 6 inches; and when the diameter of the GaAs ingot 18 is 140 mm or more, the size of the wafers is typically 6 inches or more.

Now, a wafer of the seed side end 15 of the straight body part 18 in the GaAs ingot refers to one of the wafers sliced from the straight body part 18 in the GaAs ingot, which is in an area of 20 % of the length from the seed side end 15 toward the tail side end 17 between the seed side end 15 and the tail side end 17; a wafer of the center portion 16 of the straight body part 18 in the GaAs ingot is one of the wafers sliced from the straight body part 18 in the GaAs ingot, which is in areas of 10 % (20 % in total) of the lengths from the center of straight body included in the portion 16 toward the seed side end 15 and the tail side end 17 between the center portion 16 and the seed side end 15 and between the center portion 16 and the tail side end 17; and a wafer of the tail side end 17 of the straight body part refers to one of the wafers sliced from the straight body part 18 in the GaAs ingot, which is in an area of 20 % of the length from the tail side end 17 toward the seed side end 15 between the seed side end 15 and the tail side end 17. A wafer being in an area means that the center of the wafer in the thickness direction is in the area. The number of the wafers in the area of 20 % of the length between the seed side end 15 and the tail side end 17, is for example five or less, preferably three or less although depending on the ingot production apparatus and the thickness of the wafers conforming to the SEMI standards.

In the measurements on the wafers of the seed side end 15, the wafers of the center portion 16, and the wafers of the tail side end 17, a given wafer in the wafers of the seed side end 15, a given wafer in the center portion 16, and a given wafer in the wafers of the tail side end 17 can be used, respectively. The values measured are used as the measured value of the wafers of the seed side end 15, the measured value of the wafers of the center portion 16, and the measured value of the wafers of the tail side end 17. Further, the measured value of a part facing the wafer closest to the seed side end 15 when the wafer is cut out (the cut end) is used as the measured value of the wafers of the seed side end 15, and the measured value of a part facing the wafer closest to the tail side end 17 when the wafer is cut out (the cut end) is used as the measured value of the wafers of the tail side end 17.

In the measurements, both the top and bottom surfaces of the wafers can be used for the measurements. On the other hand, for the cut ends, the surface facing the wafer of the seed side end 15 in the cutting or the surface facing the wafer of the tail side end in the cutting is used for the measurement.

The measurements of the carrier concentration, the average dislocation density, the Si concentration, the In concentration, and the boron (B) concentration are described below.

### (Method of measuring carrier concentration)

The carrier concentration is a value obtained by sampling a part with a size of 10 mm × 10 mm at the center of a wafer picked out of the wafers, heating the sample with indium electrodes being attached to the four corners to 330 °C to 360 °C, and then subjecting the sample to the Hall measurement using the Van der Pauw method.

### (Method of measuring average dislocation density)

The average dislocation density is obtained by the measurement of the etch pit density (EPD), and is measured by pretreating a surface of the wafer picked with a sulfuric acid-based mirror surface etching solution (H₂SO₄ : H₂O₂ : H₂O = 3 : 1 : 1 (volume ratio)), then immersing the wafer in a KOH melt with a liquid temperature of 320 °C for 30 min to 40 min thereby forming etch pits, and counting the etch pits.

The measurement is performed by counting the formed etch pits by defining areas with a diameter of 3 mm at 69 points in the wafer and observing the areas under a microscope.

The areas at 69 points are distributed evenly over the wafer, and the areas are defined at positions distributed at regular intervals of 5 mm in the case of a 2 in wafer, 10 mm in the case of a 4 in wafer, 15 mm in the case of a 6 in wafer, and 20 mm in the case of a 8 in wafer.

A 10x objective lens for a field diameter of 1.73 mm is used for the observation of the areas. A field of view in which the most pits are observed in the areas is found and the etch pits are counted, and the number of etch pits counted is converted to the number per unit area (cm⁻²). The average of the counts of the etch pits in the areas is used as the average dislocation density.

### (Methods of measuring Si concentration, In concentration, and B concentration)

The Si concentration, the In concentration, and the B concentration are values obtained by etching the surface of the picked wafer with an etchant (NH₄OH : H₂O₂ : H₂O = 1 : 1 : 10 (volume ratio)) to a depth of 5 µm, washing the wafer with pure water and then drying the wafer, followed by the analysis of the wafer by secondary ion mass spectrometry (SIMS).

Specifically, a depth of 0.5 µm to 1 µm from the surface is subjected to the measurements for Si and B by SIMS analysis using cesium ions at an ion energy set to 14.5 keV. A part with a depth of 3 µm from the surface is subjected to the measurement for In by SIMS analysis using oxygen ions at an ion energy set to 5.5 keV.

The ranges of the carrier concentration, the average dislocation density, the Si concentration, the In concentration, the B concentration, and others are described below. Unless otherwise specified, the ranges are applied to the seed side end 15 and the center portion 16 of the straight body part 18 in the GaAs ingot.

### (Range of carrier concentration)

The carrier concentration is 5.5 × 10¹⁷ cm⁻³ or less. The carrier concentration is preferably 1.0 × 10¹⁷ cm⁻³ or more.

According to this disclosure, even when the diameter of the GaAs ingot is 140 mm or more, the carrier concentration may be 5.5 × 10¹⁷ cm⁻³ or less.

Further, when the diameter of the GaAs ingot is less than 140 mm, the carrier concentration may be 5.0× 10¹⁷ cm⁻³ or less.

### (Range of average dislocation density)

The average dislocation density is preferably close to zero, and is 500/cm² or less.

Even when the diameter of the GaAs ingot is 140 mm or more, the average dislocation density may be 500/cm² or less. The average dislocation density in this case is preferably 450/cm² or less, more preferably 400/cm² or less.

Further, when the diameter of the GaAs ingot is less than 140 mm, the average dislocation density is 200/cm² or less. The average dislocation density in this case is preferably 150/cm² or less, more preferably 100/cm² or less.

### (Si concentration)

To obtain a low EPD crystal by the adhesion effect of dislocations, the Si concentration is 2.0 × 10¹⁷ cm⁻³ or more. On the other hand, for recent light emitting/receiving devices, free carrier absorption is believed to be preferably controlled; and since excessively high Si concentration would cause free carrier absorption and in terms of controlling the concentration, the Si concentration is less than 1.5 × 10¹⁸ cm⁻³. When Si of 1.5 × 10¹⁸ cm⁻³ or more is contained in GaAs, it is difficult to obtain a carrier concentration of 5.5 × 10¹⁷ cm⁻³ or less.

When the diameter of the GaAs ingot is 140 mm or more, the Si concentration is preferably 2.0 × 10¹⁷ cm⁻³ or more and less than 1.5 × 10¹⁸ cm⁻³.

When the diameter of the GaAs ingot is less than 140 mm, the Si concentration is preferably 2.0 × 10¹⁷ cm⁻³ or more and less than 1.0 × 10¹⁸ cm⁻³.

### (Range of In concentration)

Conventionally, in a production method by LEC, it has been believed that high In concentration is desired to obtain a GaAs crystal with low dislocation density by the adhesion effect of dislocations; however, the present inventors have found that satisfactory effects can be obtained with an In concentration in the VGF method and the VB method that is lower than that has been conventionally reported. Nevertheless, when the In concentration is less than 1.0 × 10¹⁷ cm⁻³, dislocation density reduction effects of the addition of In is hardly obtained, thus the In concentration is 1.0 × 10¹⁷ cm⁻³ or more.

When the diameter of the GaAs ingot is 140 mm or more, to secure dislocation density reduction effects, the In concentration is preferably 1.0 × 10¹⁸ cm⁻³ or more, more preferably 3.0 × 10¹⁸ cm⁻³ or more.

On the other hand, when the diameter of the GaAs ingot is less than 140 mm, satisfactory dislocation density reduction effects can be obtained when the In concentration is 1.0 × 10¹⁷ cm⁻³ or more.

On the other hand, since In behaves as a neutral impurity in GaAs, an excessively high In concentration causes deviations of the lattice constant and the band gap of the GaAs crystal in the VGF method and the VB method although it does not cause free carrier absorption; therefore, the In concentration is limited to less than 6.5 × 10¹⁸ cm⁻³ unlike in the report on GaAs crystals grown by the EC method.

When the diameter of the GaAs ingot is 140 mm or more, the In concentration is preferably 6.0 × 10¹⁸ cm⁻³ or less. The In concentration of the center portion 16 in particular is preferably 6.0 × 10¹⁸ cm⁻³ or less.

When the diameter of the GaAs ingot is less than 140 mm, the In concentration is preferably 2.0 × 10¹⁸ cm⁻³ or less. The In concentration of the center portion 16 in particular is preferably 2.0 × 10¹⁸ cm⁻³ or less.

For crystal growth, it is known that the impurity concentration increases or decreases in the direction of the crystal growth direction depending on the solubility coefficient of the impurity, and both the Si concentration and the In concentration increase from the seed side end 15 of the GaAs ingot toward the tail side end 17 thereof. As will be demonstrated in Example 2 and Example 3 to be described below, since even higher yields can be expected, when the diameter of the GaAs ingot is less than 140 mm, both the seed side end 15 and the center portion 16 have an In concentration of 4.0 × 10¹⁷ cm⁻³ or more and 2.0 × 10¹⁸ cm⁻³ or less; within this range, the average dislocation density can be sufficiently limited.

### (Range of ratio of In concentration to Si concentration)

The ratio of the In concentration to the Si concentration in each of the seed side end 15 and the center portion 16 of the straight body part 18 in the GaAs ingot (may also be referred to as In/Si or concentration ratio) is preferably 0.30 or more and 10.00 or less.

When the diameter of the GaAs ingot is 140 mm or more, the concentration ratio is preferably 4.50 or more and 10.00 or less.

When the diameter of the GaAs ingot is less than 140 mm, the concentration ratio is preferably 0.30 or more and 5.20 or less. As will be demonstrated in Example 2 and Example 3 to be described below, the concentration ratio is more preferably 1.00 or more and 3.00 or less.

### (Range of B concentration)

In the crystal growth of the GaAs ingot by the VGF method or the VB method, B₂O₃ is typically used as a liquid sealant to prevent the As from dissociation during the crystal growth. When crystal growth is performed by doping with 5.0 × 10¹⁷ cm⁻³ or more Si, in terms of controlling the Si concentration through the substitution reactions of Si with B at the start of crystal growth, 1.0 × 10¹⁸ cm⁻³ or more B is preferably contained in the GaAs ingot. The B concentration is preferably 3.0 × 10¹⁸ cm⁻³ or more.

In the crystal growth of the GaAs ingot by the VGF method or VB method with a Si concentration of less than 1.5 × 10¹⁸ cm⁻³, to control the Si concentration through the substitution reactions of Si with B, B of 6.5 × 10¹⁸ cm⁻³ or less is preferably contained in the GaAs ingot.

### (Elements other than the above and their concentrations)

Elements other than GaAs are preferably not added other than Si and In except for B and oxygen (O) that are mixed into the GaAs ingot as B₂O₃ used as a sealant; only Si and In are added as dopants, and the others are preferably not added deliberately as dopants.

The elements that may be used as the dopants other than silicon and indium include beryllium (Be), magnesium (Mg), aluminum (Al), carbon (C), germanium (Ge), tin (Sn), nitrogen (N), sulfur (S), selenium (Se), tellurium (Te), and also include zinc (Zn), cadmium (Cd), chromium (Cr), and antimony (Sb); although these elements are allowed to be incorporated to an amount inevitably mixed in, yet are preferably not added deliberately.

For example, the concentrations of Al, C, and Zn in GaAs found by SIMS analysis are each preferably 3.0 × 10¹⁶ cm⁻³ or less (including zero). The concentrations of Be, Mg, Ge, Sn, N, S, Se, Te, Cd, Cr, and Sb other than the above elements are each preferably 5.0 × 10¹⁵ cm⁻³ or less (including zero). Further, the N concentration is more preferably 1.0 × 10¹⁵ cm⁻³ or less.

### < Method of producing GaAs ingot >

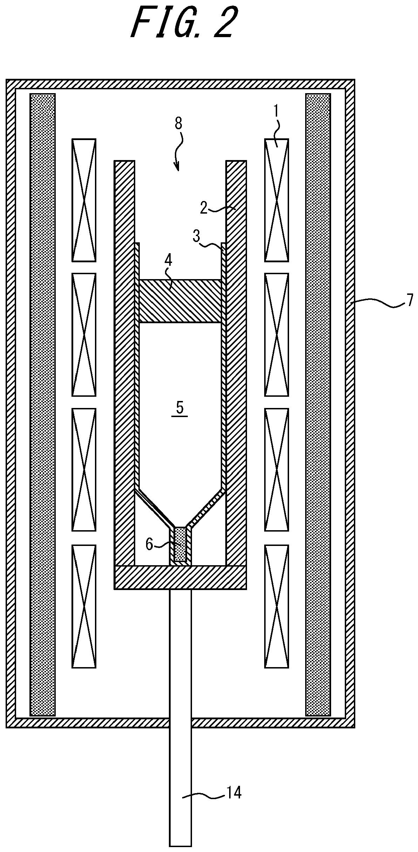

When a silicon doped n-type GaAs ingot is produced by the VGF method or the VB method, typically, a GaAs melt to which Si is added as a polycrystalline source melt is used and B₂O₃ is used as a liquid sealant; instead, in the production of a GaAs ingot of this disclosure, In is added in addition to Si. The following description is made with reference to FIGS. 2 to 4.

### (Production apparatus and temperature control)

FIG. 2 is a cross-sectional view schematically illustrating an example of a production apparatus for producing a GaAs ingot of this disclosure. The production apparatus depicted in FIG. 2 includes an airtight container 7 than can be evacuated and filled with the ambient gas from the outside; a crucible 3 placed at the center inside the airtight container 7; a crucible receiving container (susceptor) 2 in which the crucible 3 is held; a mechanism 14 for elevating and/or rotating the crucible receiving container (susceptor) 2 (only an elevating/rotating rod is depicted); and a heater 1 provided to surround the crucible receiving container (susceptor) 2 inside the airtight container 7. The crucible 3 may use one made of pyrolytic boron nitride (PBN). In FIG. 2, the crucible 3 is charged with the seed crystal 6, a compound semiconductor feedstock 5, and the sealant (B₂O₃) 4, and the airtight container 7 is for example filled with an inert gas 8.

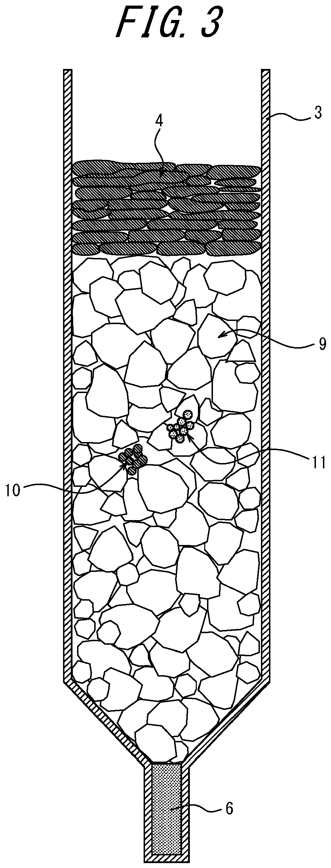

FIG. 3 is a cross-sectional view illustrating an example of a crucible for producing a GaAs ingot of this disclosure, and corresponds to a state before crystal growth where the crucible is charged with the feedstock and others. The crucible 3 is charged with the seed crystal 6, the polycrystalline GaAs feedstock 9, a dopant (silicon) 10 in the case of a typical silicon doped n-type GaAs ingot, and a sealant (B₂O₃) 4. The sealant (B₂O₃) 4 is used with a view to controlling the flying of As and the Si concentration at the start of crystal growth, and since the sealant has a lower density than GaAs, and a melting point (480 °C) significantly lower than the melting point of GaAs (1238 °C), it can cover the top of the feedstock melt in the growth of a single crystal. In this disclosure, for dopants, a dopant (indium) 11 is charged as a feedstock in addition to the dopant (silicon) 10.

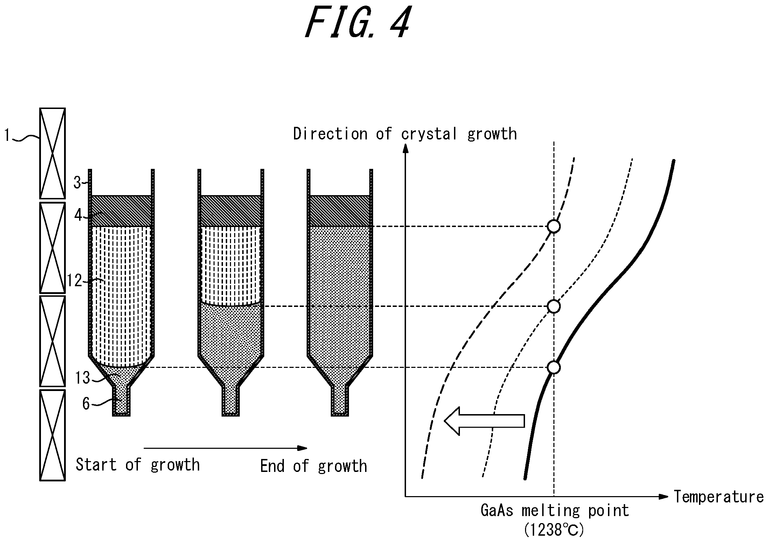

After charging them, in the growth furnace filled with an inert gas, a temperature gradient is applied to the heater controlled to make the temperature on the seed crystal 6 side lower using a PID controller to prevent the seed crystal 6 from being melted, and meanwhile the polycrystalline GaAs feedstock 9 is heated to the melting point of GaAs: 1238 °C or higher to melt all the polycrystalline GaAs feedstock 9, the dopant (silicon) and the dopant (indium) 11, and the sealant (B₂O₃) 4. Next, the temperature around the seed crystal 6 is raised, and when an upper part of the seed crystal 6 melts, the temperature of all area is gradually lowered while applying a temperature gradient, thus a GaAs ingot can be obtained. The cooling rate here is 10 °C/h or less. FIG. 4 schematically illustrates the relationship between the state inside the crucible and the temperature gradient from the start of crystal growth to the end of crystal growth.

### (Seed crystal)

The size of the seed crystal 6 is not necessarily a size having a cross-sectional area of 25 % or more of a body part of the single crystal to be grown as in PTL 1, and the seed crystal 6 may have for example a cross-sectional area of 1 % to 20 % of a cross-sectional area having an inner diameter that is the inner diameter of the crucible 3 and preferably has a cross-sectional area of 3 % to 17 % thereof. When the intended diameter of a crystal grown to be grown is 140 mm or more, the cross-sectional area of the seed crystal 6 may be 2 % to 10 % of the cross-sectional area having a diameter that is the crucible inner diameter.

Even when the size of the seed crystal 6 is small, a GaAs ingot having a carrier concentration 5.5 × 10¹⁷ cm⁻³ or less and low dislocation density can be obtained when both Si and In are contained in an amount in certain ranges as in this disclosure. The inner diameter of the crucible 3 is preferably slightly larger than an intended wafer size. The intended wafer size may be appropriately selected for example from 2 in to 8 in.

### (Dopant)

The dopant (silicon) 10 is added into the polycrystalline GaAs feedstock 9 in a weight controlled to a desired concentration by, for example, a high purity Si shot or crushing a high purity Si substrate. Further, the dopant (indium) is added into the polycrystalline GaAs feedstock 9 in a weight controlled to obtain a desired concentration using high purity In, or an indium compound (for example, high purity indium arsenide (InAs)). For example, when Si is added, the amount of silicon charged may be, but not limited to, 60 wt ppm or more and 130 wt ppm or less with respect to the polycrystalline GaAs feedstock; and when InAs is added, the amount of indium charged may be, but not limited to, 36 wt ppm or more and 2000 wt ppm or less with respect to the polycrystalline GaAs feedstock.

When the diameter of the GaAs ingot is 140 mm or more, the amount of silicon charged is preferably 70 wt ppm or more and 130 wt ppm or less, and the amount of indium charged is preferably 75 wt ppm or more and 2000 wt ppm or less. The amount of indium charged corresponds to approximately 125 wt ppm or more and approximately 3300 wt ppm or less of InAs.

On the other hand, when the diameter of the GaAs ingot is less than 140 mm, the amount of silicon charged is preferably 60 wt ppm or more and 90 wt ppm or less, and the amount of indium charged is preferably 36 wt ppm or more and 605 wt ppm or less. The amount of indium charged corresponds to 60 wt ppm or more and 1000 wt ppm or less of InAs.

The melting point of In is 156 °C and the melting point of InAs is 942 °C; they are much lower than the melting point of GaAs: 1238 °C. Before the start of GaAs crystal growth, if In having melted first is deposited around the seed crystal 6, single crystallization is hindered; thus, it is necessary to contrive ways to prevent it from easily being deposited around the seed crystal 6 by adding the dopant (indium) 11 to a position separate from the seed crystal 6 or appropriately placing the polycrystalline GaAs feedstock 9 as in FIG. 3.

Examples of the ways are as follows, and one or more of them are preferably used.

The dopant (indium) 11 is placed above the center of the crucible (position corresponding to the center portion of the ingot).

The dopant (indium) 11 is put into a container made of a GaAs crystal or polycrystalline GaAs (GaAs container), and the dopant is kept from going out of the container before the temperature reaches the temperature at which the GaAs container melts.

Note that the dopant (silicon) 10 is preferably placed below the center of the crucible (position corresponding to the center portion of the ingot) (the seed crystal side). Alternatively, the dopant (silicon) 10 may be put into the GaAs container, and the dopant may be kept from going out of the container before the temperature reaches the temperature at which the GaAs container melts. Since silicon has lower density than GaAs, in the melt, the dopant (silicon) floats up, so that the silicon concentration in the GaAs melt on the seed crystal side becomes low, and the silicon concentration of the GaAs ingot on the seed side would be low. The use of the GaAs container is advantageous in avoiding such a situation.

Further, to prevent In from easily being deposited around the seed crystal 6, the size of the seed crystal 6 is preferably small, and the size of the seed crystal 6 is preferably in the above range.

### (Sealant (B₂O₃))

The sealant (B₂O₃) 4 may use one containing silicon. The silicon concentration may be 10 wt% or less. Silicon may be contained in the form of Si oxide in the sealant (B₂O₃) 4.

For example, the sealant (B₂O₃) 4 having a silicon concentration of 1 wt % or more and 7 wt% or less may be used. In this case, during the GaAs crystal growth, the sealant (B₂O₃) 4 is preferably stirred. Stirring can control the variation of the Si concentration in the GaAs ingot, which can reduce the carrier concentration. This process is particularly advantageous in the production of a GaAs ingot having a diameter of 140 mm or more.

The stirring process is not limited and may be performed by for example after placing the sealant (B₂O₃) 4 on the polycrystalline GaAs feedstock 9, placing a stirring means (for example, a predetermined number of stirring plates attached to a rotation shaft) may be placed in the sealant (B₂O₃) 4, and performing crystal growth while the sealant (B₂O₃) 4 is stirred by rotation. In stirring, it is preferred that the stirring means is kept from being in contact with the interface between the melt of the polycrystalline GaAs feedstock 9 and the sealant (B₂O₃) 4.

The above production method is one example, and conventional known methods may be added to adjust the concentrations of Si, In, and B incorporated into the GaAs ingot during the crystal growth.

### < GaAs wafer >

In a GaAs ingot of this disclosure, a seed side end and a center portion each have a silicon concentration of 2.0 × 10¹⁷ cm⁻³ or more and less than 1.5 × 10¹⁸ cm⁻³, an indium concentration of 1.0 × 10¹⁷ cm⁻³ or more and less than 6.5 × 10¹⁸ cm⁻³, a carrier concentration of 5.5 × 10¹⁷ cm⁻³ or less, and an average dislocation density of 500/cm² or less. Accordingly, when a wafer is cut out from this GaAs ingot between the seed side end and the center portion, a GaAs wafer having a silicon concentration of 2.0 × 10¹⁷ cm⁻³ or more and less than 1.5 × 10¹⁸ cm⁻³, an indium concentration of 1.0 × 10¹⁷ cm⁻³ or more and less than 6.5 × 10¹⁸ cm⁻³, a carrier concentration of 5.5 × 10¹⁷ cm⁻³ or less, and an average dislocation density of 500/cm² or less can be obtained.

According to this disclosure, a GaAs wafer having a silicon concentration of 2.0 × 10¹⁷ cm⁻³ or more and less than 1.0 × 10¹⁸ cm⁻³, an indium concentration of 1.0 × 10¹⁷ cm⁻³ or more and less than 3.0 × 10¹⁸ cm⁻³, a carrier concentration of 5.0 × 10¹⁷ cm⁻³ or less, and an average dislocation density of 200/cm² or less can be obtained from a GaAs ingot having a diameter of less than 140 mm.

Further, according to this disclosure, a GaAs wafer having a silicon concentration of 2.0 × 10¹⁷ cm⁻³ or more and less than 1.5 × 10¹⁸ cm⁻³, an indium concentration of 1.0 × 10¹⁸ cm⁻³ or more and less than 6.5 × 10¹⁸ cm⁻³, a carrier concentration of 5.5 × 10¹⁷ cm⁻³ or less, and an average dislocation density of 500/cm² or less can be obtained from the seed side end and the center portion of the straight body part of a GaAs ingot having a diameter of 140 mm or more.

The above shows examples of exemplary embodiments of this disclosure, and this disclosure is not limited to these embodiments. The following provides a more detailed description of a method of producing a GaA ingot according to this disclosure using examples. However, this disclosure is not in any way limited by the following examples.

### EXAMPLES

### (Example 1)

A GaAs ingot was produced using a production apparatus having a structure illustrated in FIG. 2.

### < Charging feedstock into crucible >

A PBN crucible with a crucible inner diameter of 58.8 mm and a seed part inner diameter of 6.3 mm was prepared as a crucible. As illustrated in FIG. 3, the crucible is charged with a 3200 g polycrystalline GaAs feedstock obtained by crushing polycrystalline GaAs prepared by synthesizing 6N (purity: 99.9999 % or more) Ga and 6N As, and a GaAs seed crystal cut out so that the (100) plane would be a crystal growth surface. The GaAs seed crystal used had a diameter of 6.0 mm. While charging the polycrystalline GaAs, a high purity Si shot was charged as a dopant (silicon) in 80 wt ppm with respect to the polycrystalline GaAs feedstock, and high purity InAs was charged as a dopant (indium) in 125 wt ppm (76 wt ppm In) with respect to the polycrystalline GaAs feedstock. No impurity element was deliberately added other than Si and In.

Note that the powder dopant (silicon) and the dopant (indium) were each charged while being contained in a GaAs container constituted by cylindrical polycrystalline GaAs of which top and bottom are stopped by polycrystalline GaAs shaped like discs, and the dopants were kept from going out of the GaAs container before the temperature reached the temperature at which the GaAs containers melted. The dopant (indium) was placed above the center of the crucible, and the dopant (silicon) was placed near the seed crystal below the center of the crucible.

### < Crystal growth >

After charging these feedstocks, 125 g of B₂O₃ (Si concentration: 7 wt%) was charged as a sealant. After charging, the crucible was placed in a crucible receiving container (susceptor). The inside of the production apparatus depicted in FIG. 2 was repeatedly evacuated and purged with Ar gas to obtain an inert gas atmosphere, and a single crystal was then grown by the VGF method.

In the step of crystal growth, first, the feedstocks in the crucible were heated to the melting point of GaAs: 1238 °C or higher while applying a temperature gradient using a heater controlled using a PID controller so that the temperature on the seed crystal side would be lower to prevent the GaAs seed crystal from melting. After that, after raising the temperature around the seed crystal to melt the top of the seed crystal, the temperature in the whole furnace was lowered at a rate of 10 °C/h or less while applying a temperature gradient by heater control, thus an n-type GaAs ingot was grown using Si and In as dopants.

### < Evaluation >

A straight body part of the GaAs ingot grown was sliced into wafers using a wire saw. The wafer size was 2 in worth.

One obtained from the straight body part of the GaAs ingot at a position closest to the seed as a first wafer and a disc of the cut end having a part of the cone part having a surface facing the surface of the first wafer on the seed side (also referred to as a zeroth wafer) as one of the seed side end (Seed) were evaluated.

When the straight body part of the GaAs ingot was sliced into wafers, a wafer of the middle position between the seed side end and the tail side end illustrated in FIG. 1 (when the position was on the cut surfaces, two wafers having the surfaces) was evaluated as a wafer of the center portion (Middle).

The last wafer counted from the above first wafer, obtained from the straight body part of the GaAs ingot at a position closest to the tail and a wafer having a surface facing the surface of the last wafer on the seed side were evaluated as wafers of the tail side end (Tail). The last cut surface was at a position of 20 mm from the end of the ingot opposite to the seed crystal (in the seed direction), corresponding to the tail side end 17 in FIG. 1.

A part with a size of 10 mm × 10 mm was sampled from an area including the center of the crystal of one of the sliced wafers or the cut end (wafer center portion) using the cleavage of the (110) plane, and the carrier concentration of the sample was measured by the Hall measurement using the Van der Pauw method.

After performing pretreatments on the remainder of the wafer or the cut end used in the Hall measurement, and the Si concentration, the In concentration, and the B concentration of the remainder were measured by SIMS analysis using a system manufactured by CAMECA.

A wafer surface next to (having a surface next to the same cut plane with) the wafer or the cut end used in the above Hall measurement was subjected to the measurement of the EPD as described above, and the EPD was evaluated as the average dislocation density.

In the GaAs ingot obtained, when the carrier concentration was 5.0 × 10¹⁷ cm⁻³ or less and the average dislocation density was as low as 200/cm² or less in both the wafer of the seed side end and the wafer of the center portion, all the wafers between the seed side end and the center portion (50 % of all the wafers) had a carrier concentration of 5.0 × 10¹⁷ cm⁻³ or less and an average dislocation density of 200/cm² or less.

### (Example 2)

A GaAs ingot of Example 2 was obtained and evaluated in the same manner as in Example 1 except that while charging the GaAs polycrystalline feedstock, 300 wt ppm of high purity InAs, 80 wt ppm of a high purity silicon shot were charged.

Further, in addition to the wafers of the seed side end (Seed), the center portion (Middle), and the tail side end (Tail), a wafer at a position between the center portion and the tail side end (78 % from the seed side end) was also subjected to the evaluation.

### (Example 3)

A GaAs ingot of Example 3 was obtained and evaluated in the same manner as in Example 1 except that while charging the GaAs polycrystalline feedstock, 500 wt ppm of high purity InAs, 80 wt ppm of a high purity silicon shot were charged.

Further, in addition to the wafers of the seed side end (Seed), the center portion (Middle), and the tail side end (Tail), a wafer at a position between the center portion and the tail side end (78 % from the seed side end) was also subjected to the evaluation.

### (Example 4)

An n-type GaAs ingot was grown using Si and In as dopants in the same manner as in Example 1 except that a PBN crucible having a crucible inner diameter of 159.9 mm and a seed part inner diameter of 6.0 mm to 6.5 mm was used as a crucible; 20,000 g of the polycrystalline GaAs feedstock, 80 wt ppm of a high purity Si shot with respect to the polycrystalline GaAs feedstock, 2000 wt ppm high purity InAs with respect to the polycrystalline GaAs feedstock (1210 wt ppm In), 965 g B₂O₃ (Si concentration: 7 wt%) as a sealant, and a GaAs seed crystal having a diameter of 6.0 mm were used.

Evaluation was performed in the same manner as in Example 1 except that a straight body part of the GaAs ingot grown was sliced into wafers of 6 in worth.

### (Comparative Example 1)

A GaAs ingot was obtained and evaluated in the same manner as in Example 4 except that while charging the GaAs polycrystalline feedstock, 60 wt ppm silicon was charged in a high purity silicon shot, and high purity InAs was not added.

### (Comparative Example 2)

A GaAs ingot was obtained and evaluated in the same manner as in Example 4 except that while charging the GaAs polycrystalline feedstock, 100 wt ppm silicon was charged in a high purity silicon shot, and high purity InAs was not added.

### (Comparative Example 3)

A GaAs ingot was obtained and evaluated in the same manner as in Example 4 except that while charging the GaAs polycrystalline feedstock, 220 wt ppm silicon was charged in a high purity silicon shot, and high purity InAs was not added.

### (Comparative Example 4)

A GaAs crystal was obtained and evaluated in the same manner as in Example 4 except that while charging the GaAs polycrystalline feedstock, 240 wt ppm silicon was charged in a high purity silicon shot, and high purity InAs was not added.

### (Comparative Example 5)

A GaAs crystal was obtained and evaluated in the same manner as in Example 4 except that while charging the GaAs polycrystalline feedstock, 80 wt ppm silicon was charged in a high purity silicon shot, and 5000 wt ppm high purity InAs (3026 wt ppm indium) was charged.

The results of Examples 1 to 5 and Comparative Examples 1 to 5 are given in Table 1.

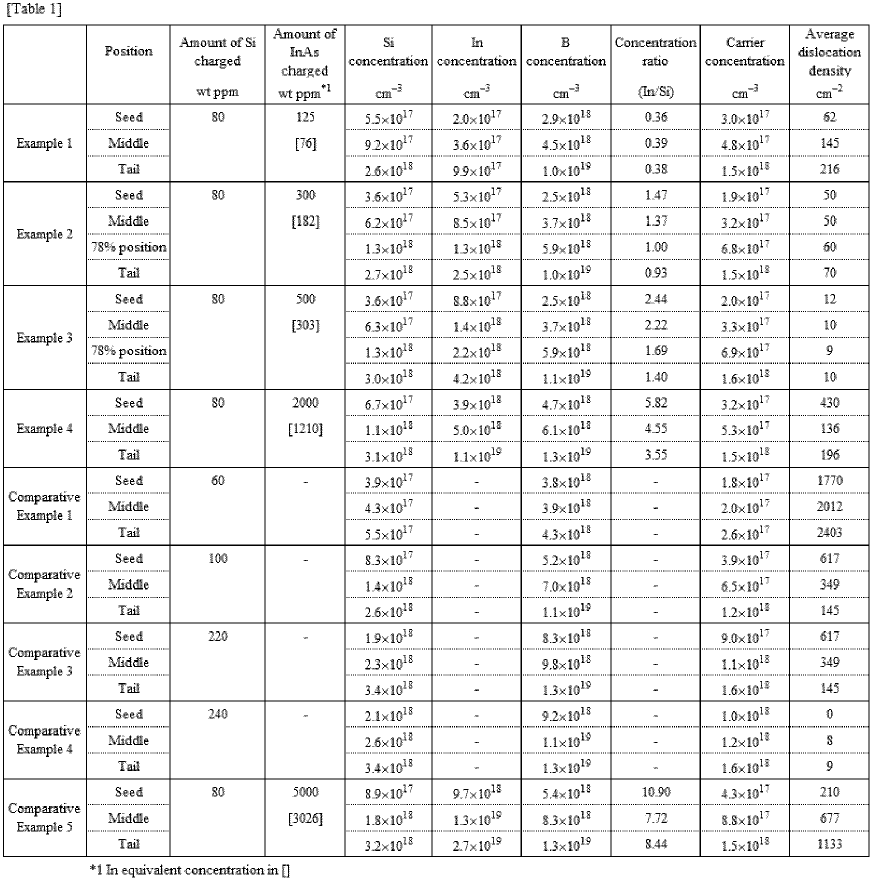

The conductivity type of the GaAs ingot obtained was an n-type.

Examples 1 to 3 are examples in which a GaAs ingot having a diameter of less than 140 mm was produced, and in the measurement on each of the wafer of the seed side end of the straight body part of the GaAs ingot and the wafer of the center portion thereof, when each wafer had a silicon concentration of 2.0 × 10¹⁷ cm⁻³ or more and less than 1.0 × 10¹⁸ cm⁻³, an indium concentration of 1.0 × 10¹⁷ cm⁻³ or more and less than 3.0 × 10¹⁸ cm⁻³; a GaAs wafer (2 in wafer) having a carrier concentration of 5.0 × 10¹⁷ cm⁻³ or less and an average dislocation density of 200/cm² or less was found to be obtained.

In Example 1, the carrier concentration of the center portion was 4.8 × 10¹⁷; on the other hand, the carrier concentration of the center portion was 3.2 × 10¹⁷ in Example 2, and was 3.3 × 10¹⁷ in Example 3, which was expected to provide even higher yield in obtaining the above wafer.

Example 4 is an example in which a GaAs ingot having a diameter of 140 mm or more is produced, and in the measurement on each of the wafer of the seed side end of the straight body part of the GaAs ingot and the wafer of the center portion thereof, when each wafer had a silicon concentration of 2.0 × 10¹⁷ cm⁻³ or more and less than 1.5 × 10¹⁸ cm⁻³, an indium concentration of 1.0 × 10¹⁷ cm⁻³ or more and less than 6.0 × 10¹⁸ cm⁻³; a GaAs wafer (6 in wafer) having a carrier concentration of 5.5 × 10¹⁷ cm⁻³ or less and an average dislocation density of 500/cm² or less was found to be obtained.

### (Example 5)

A GaAs crystal was obtained and evaluated in the same manner as in Example 4 except that while charging the GaAs polycrystalline feedstock, 100 wt ppm silicon was charged in a high purity silicon shot, and 2000 wt ppm high purity InAs (1210 wt ppm indium) was charged, B₂O₃ (Si concentration: 5 wt%) was used as a sealant, and the sealant was stirred while the GaAs crystal was grown. The stirring of the sealant was performed by stirring by rotation using a stirring means after placing the sealant on the polycrystalline GaAs feedstock, placing the stirring means in which four plate-shaped stirring plates are attached to a rotation shaft is placed in the sealant, and keeping the lower end of the stirring means polycrystalline GaAs feedstock from being in contact with the interface between the melt and the sealant.

### (Example 6)

A GaAs crystal was obtained and evaluated in the same manner as in Example 5 except that while charging the GaAs polycrystalline feedstock, 100 wt ppm silicon was charged in a high purity silicon shot, and 2000 wt ppm high purity InAs (1210 wt ppm indium) was charged, and B₂O₃ (Si concentration: 2 wt%) was used as a sealant.

### (Example 7)

A GaAs crystal was obtained and evaluated in the same manner as in Example 5 except that while charging the GaAs polycrystalline feedstock, 100 wt ppm silicon was charged in a high purity silicon shot, and 2500 wt ppm high purity InAs (1513 wt ppm indium) was charged, and B₂O₃ (Si concentration: 5 wt%) was used as a sealant.

The results of Examples 5 to 7 are given in Table 2. Table 2 also newly gives the results of Example 4.

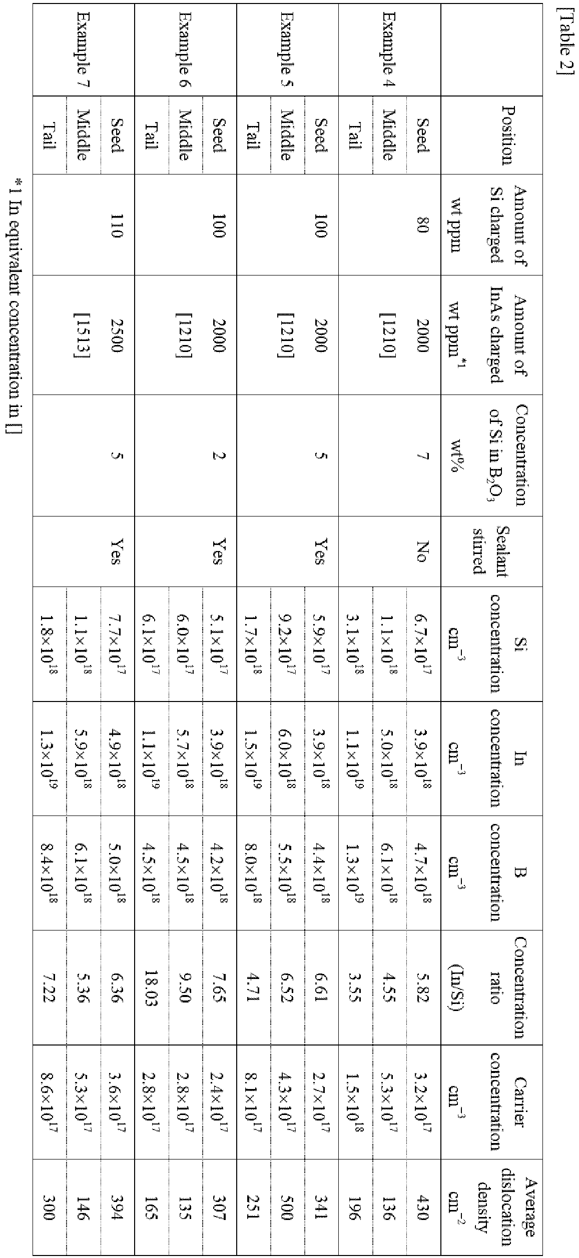

The conductivity type of the GaAs ingot obtained was an n-type.

Table 2 demonstrates that when B₂O₃ containing silicon is used as a sealant and the sealant is stirred during the GaAs single crystal growth; the Si concentration in the ingot can be hindered from varying, and the carrier concentration can be reduced.

### INDUSTRIAL APPLICABILITY

This disclosure provides a GaAs ingot with which a GaAs wafer having a carrier concentration of 5.5 × 10¹⁷ cm⁻³ or less and low dislocation density with an average dislocation density of 500/cm² or less can be obtained by adding a small amount of In with Si. This disclosure provides a GaAs ingot with which a GaAs wafer having a carrier concentration of 5.5 × 10¹⁷ cm⁻³ or less and an average dislocation density of 500/cm² or less can be obtained even when the wafer has a large diameter of 140 mm or more, and can provide a GaAs ingot with which a GaAs wafer having a carrier concentration of 5.0 × 10¹⁷ cm⁻³ or less and an average dislocation density of 200/cm² or less can be obtained when the wafer has a diameter of less than 140 mm.

### REFERENCE SIGNS LIST

1: Heater
2: Crucible receiving container (susceptor)
3: Crucible
4: Sealant (B₂O₃)
5: Compound semiconductor feedstock
6: Seed crystal
7: Airtight container
8: Inert gas
9: Polycrystalline GaAs feedstock
10: Dopant (silicon)
11: Dopant (indium)
12: Feedstock melt
13: Solid forming GaAs crystal
14: Crucible elevating/rotating mechanism
15: Seed side end of GaAs ingot
16: Center portion of GaAs ingot
17: Tail side end of GaAs ingot
18: Straight body part of GaAs ingot
19: Cone part of GaAs ingot

## Claims

1. A GaAs ingot comprising a straight body part,
wherein a seed side end and a center portion of the straight body part each have a silicon concentration of 2.0 × 10¹⁷ cm⁻³ or more and less than 1.5 × 10¹⁸ cm⁻³, an indium concentration of 1.0 × 10¹⁷ cm⁻³ or more and less than 6.5 × 10¹⁸ cm⁻³, a carrier concentration of 5.5 × 10¹⁷ cm⁻³ or less, and an average dislocation density of 500/cm² or less.

2. The GaAs ingot according to Claim 1, wherein the indium concentration in the center portion of the straight body part is 6.0 × 10¹⁸ cm⁻³ or less.

3. The GaAs ingot according to Claim 1 or 2, wherein the boron concentration in each of the seed side end and the center portion of the straight body part is 1.0 × 10¹⁸ cm⁻³ or more and 6.5 × 10¹⁸ cm⁻³ or less.

4. The GaAs ingot according to any one of Claims 1 to 3, wherein a ratio of the indium concentration to the silicon concentration for each of the seed side end and the center portion of the straight body part is 0.30 or more and 10.00 or less.

5. The GaAs ingot according to any one of Claims 1 to 4, wherein the concentrations of aluminum, carbon, and zinc in each of the seed side end and the center portion of the straight body part are 3.0 × 10¹⁶ cm⁻³ or less; and the concentrations of beryllium, magnesium, germanium, tin, nitrogen, sulfur, selenium, tellurium, cadmium, chromium, and antimony are 5.0 × 10¹⁵ cm⁻³ or less in each of the seed side end and the center portion of the straight body part.

6. The GaAs ingot according to any one of Claims 1 to 5, wherein the diameter of the GaAs ingot is less than 140 mm; and the seed side end and the center portion of the straight body part of the GaAs ingot each have a silicon concentration of 2.0 × 10¹⁷ cm⁻³ or more and less than 1.0 × 10¹⁸ cm⁻³, an indium concentration of 1.0 × 10¹⁷ cm⁻³ or more and less than 3.0 × 10¹⁸ cm⁻³, a carrier concentration of 5.0 × 10¹⁷ cm⁻³ or less, and an average dislocation density of 200/cm² or less.

7. The GaAs ingot according to Claim 6, wherein the indium concentration in the center portion of the straight body part is 2.0 × 10¹⁸ cm⁻³ or less.

8. The GaAs ingot according to Claim 6 or 7, wherein the boron concentration in each of the seed side end and the center portion of the straight body part is 1.0 × 10¹⁸ cm⁻³ or more and 5.0 × 10¹⁸ cm⁻³ or less.

9. The GaAs ingot according to any one of Claims 6 to 8, wherein a ratio of the indium concentration to the silicon concentration for each of the seed side end and the center portion of the straight body part is 0.30 or more and 5.20 or less.

10. The GaAs ingot according to any one of Claims 1 to 5, wherein the diameter of the GaAs ingot is 140 mm or more; and the seed side end and the center portion of the straight body part of the GaAs ingot each have a silicon concentration of 2.0 × 10¹⁷ cm⁻³ or more and less than 1.5 × 10¹⁸ cm⁻³, an indium concentration of 1.0 × 10¹⁸ cm⁻³ or more and less than 6.5 × 10¹⁸ cm⁻³, a carrier concentration of 5.5 × 10¹⁷ cm⁻³ or less, and an average dislocation density of 500/cm² or less.

11. The GaAs ingot according to Claim 10, wherein the indium concentration in the center portion of the straight body part is 6.0 × 10¹⁸ cm⁻³ or less.

12. The GaAs ingot according to Claim 10 or 11, wherein the boron concentration in each of the seed side end and the center portion of the straight body part is 1.0 × 10¹⁸ cm⁻³ or more and 6.5 × 10¹⁸ cm⁻³ or less.

13. The GaAs ingot according to any one of Claims 10 to 12, wherein a ratio of the indium concentration to the silicon concentration for each of the seed side end and the center portion of the straight body part is 4.50 or more and 10.00 or less.

14. A method of producing a GaAs ingot by a vertical temperature gradient method or a vertical Bridgman method using silicon as a dopant and using boron oxide as a sealant,
wherein indium is used together with silicon as the dopant,
wherein the seed side end and the center portion of the straight body part of the GaAs ingot each have a silicon concentration of 2.0 × 10¹⁷ cm⁻³ or more and less than 1.5 × 10¹⁸ cm⁻³ and an indium concentration of 1.0 × 10¹⁷ cm⁻³ or more and less than 6.5 × 10¹⁸ cm⁻³.

15. The method of producing a GaAs ingot, according to Claim 14, wherein only silicon and indium are used as the dopant.

16. The method of producing a GaAs ingot, according to Claim 14 or 15, wherein an amount of silicon charged is 60 wt ppm or more and 130 wt ppm or less with respect to a GaAs feedstock, and an amount of indium charged is 36 wt ppm or more and 2000 wt ppm or less with respect to the GaAs feedstock.

17. The method of producing a GaAs ingot, according to anyone of Claims 14 to 16, wherein the sealant is boron oxide containing 1 wt% or more and 7 wt% or less silicon, and is stirred during growth of a GaAs single crystal.

18. The method of producing a GaAs ingot, according to any one of Claims 14 to 17, wherein the GaAs ingot has a diameter of less than 140 mm, an amount of silicon charged is 60 wt ppm or more and 90 wt ppm or less with respect to the GaAs feedstock, and an amount of indium charged is 36 wt ppm or more and 605 wt ppm or less with respect to the GaAs feedstock.

19. The method of producing a GaAs ingot, according to any one of Claims 14 to 17, wherein the GaAs ingot has a diameter of 140 mm or more, an amount of silicon charged is 70 wt ppm or more and 130 wt ppm or less with respect to the GaAs feedstock, and an amount of indium charged is 75 wt ppm or more and 2000 wt ppm or less with respect to the GaAs feedstock.

20. A GaAs wafer comprising:
silicon with a concentration of 2.0 × 10¹⁷ cm⁻³ or more and less than 1.5 × 10¹⁸ cm⁻³;
indium with a concentration of 1.0 × 10¹⁷ cm⁻³ or more and less than 6.5 × 10¹⁸ cm⁻³; and
carriers with a concentration of 5.5 × 10¹⁷ cm⁻³ or less,
wherein an average dislocation density of the GaAs wafer is 500/cm² or less.

21. The GaAs wafer according to Claim 20, wherein the diameter of the GaAs wafer is less than 140 mm, a silicon concentration is 2.0 × 10¹⁷ cm⁻³ or more and less than 1.0 × 10¹⁸ cm⁻³, an indium concentration is 1.0 × 10¹⁷ cm⁻³ or more and less than 3.0 × 10¹⁸ cm⁻³, a carrier concentration is 5.0 × 10¹⁷ cm⁻³ or less, and an average dislocation density is 200/cm² or less.

22. The GaAs wafer according to Claim 20, wherein the diameter of the GaAs wafer is 140 mm or more; the seed side end and the center portion of the straight body part of the GaAs ingot each have a silicon concentration of 2.0 × 10¹⁷ cm⁻³ or more and less than 1.5 × 10¹⁸ cm⁻³, an indium concentration of 1.0 × 10¹⁸ cm⁻³ or more and less than 6.5 × 10¹⁸ cm⁻³, a carrier concentration of 5.5 × 10¹⁷ cm⁻³ or less, and an average dislocation density of 500/cm² or less.
